# EUROPEAN PATENT SPECIFICATION

(11) **EP 1 626 443 B1**
(45) Date of publication and mention of the grant of the patent: **18.12.2013**
(21) Application number: 04733911.4
(22) Date of filing: 19.05.2004
(51) Int. Cl.: H01L 31/04

(54) **ELECTRODE WIRE MATERIAL AND SOLAR BATTERY HAVING CONNECTION LEAD FORMED OF THE WIRE MATERIAL**
ELEKTRODENDRAHTMATERIAL UND SOLARBATTERIE MIT EINEM ANSCHLUSSDRAHT AUF DIESEM DRAHTMATERIAL
MATERIAU DE FIL-ELECTRODE ET BATTERIE SOLAIRE MUNIE D'UN FIL DE CONNEXION CONSTITUE DU MATERIAU DE FIL

(30) Priority: 22.05.2003 JP 2003144205
(43) Date of publication of application: 15.02.2006
(73) Proprietor: Neomax Materials Co., Ltd., Suita-shi, Osaka 564-0043 (JP)
(72) Inventor: SHIOMI, Kazuhiro, c/o NEOMAX MATERIALS CO., Ltd, Suita-shi, Osaka 5640043 (JP); FUJITA, Toshiaki, c/o NEOMAX MATERIALS CO., Ltd, Suita-shi, Osaka 5640043 (JP); ISHIO, Masaaki, c/o NEOMAX MATERIALS CO., Ltd, Suita-shi, Osaka 5640043 (JP)
(74) Representative: Hering, Hartmut
(86) International application number: PCT/JP2004/006725
(87) International publication number: WO 2004/105141

(56) References cited:
- JP-A- 7 099 331
- JP-A- 7 243 014
- JP-A- 11 021 660
- JP-A- 60 015 937
- JP-A- 2001 339 089
- JP-A- 2002 263 880
- US-A- 5 151 373

## Description

### TECHNICAL FIELD

The invention relates to an electrode wire material to be used as a connection lead wire of electronic parts such as solar cells.

### BACKGROUND ART

Solar cells respectively comprise a semiconductor substrate of a silicon semiconductor having PN junction and connection lead wires soldered to a plurality of front face electrodes formed linearly on the surface of the semiconductor substrate and in general, a plurality of such solar cells are connected in series so as to obtain a desired electromotive force. The series connection is done by connecting connection lead wires soldered to a front electrode of one solar cell to a rear electrode of another solar cell.

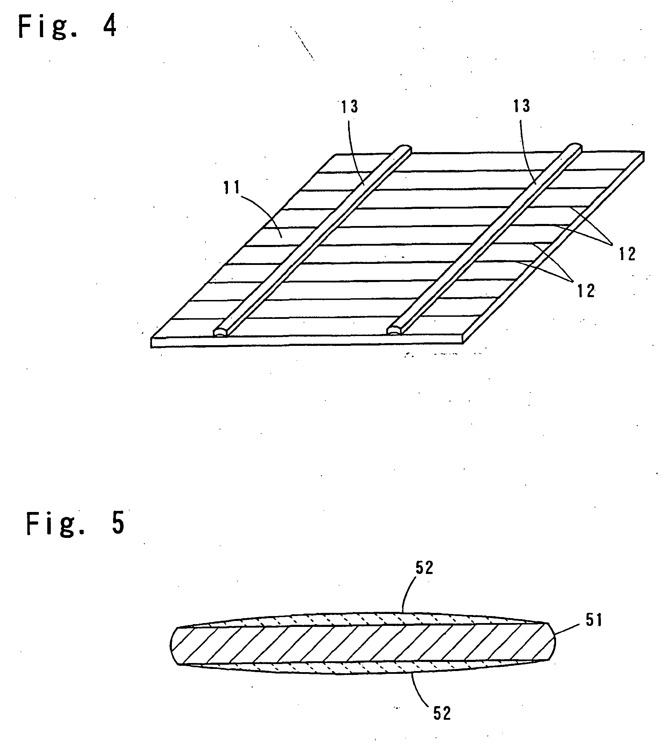

The electrode wire material before the connection lead wires being soldered to the front electrode of the semiconductor substrate comprises a core material 51 of a pressed copper wire pressed to be flat by rolling a copper wire having a circular cross section and hot-dip solder plated layers 52, 52 formed on the both faces of the core material. As shown in Fig.5, the hot-dip solder plated layers 52, 52 are formed on both faces of the core material 51 by hot dip plating method, that is, the layers formed by passing the core material 51 whose surface is cleaned by acid pickling or the like through a molten solder bath. The hot-dip solder plated layer 52 has a hill-like shape expanded toward the center part from the end parts as shown in Fig. 5 by surface tension at the time of solidification of the molten solder deposited on the core material 51.

At the time of soldering the electrode wire material to the semiconductor substrate, the heating temperature is strictly controlled to be a temperature around the melting point of the solder material. The reason for that is because the thermal expansion coefficient of copper forming the core material 51 of the electrode wire material and that of, for example, silicon forming the semiconductor substrate are quite different from each other. That is, soldering is carried out at a low temperature so as to suppress the heat stress, which causes cracking in a costly semiconductor substrate, as much as possible. The heating at the time of soldering is generally carried out by heating with a hot plate on which the semiconductor substrate is mounted and heating the electrode wire material mounted on the semiconductor substrate from the upper side in combination.

However, as shown in Fig. 5, since the hot-dip solder plated layer of the electrode wire material has the hill-like shape expanded in the center part, at the time of soldering the electrode wire material to the front electrodes of the semiconductor substrate, the contact region of the solder belt formed previously on the surface of the semiconductor substrate for easy electric communication to the front electrodes and the hot-dip solder plated layer becomes narrow and the heat transmission from the semiconductor substrate side to the hot-dip solder plated layer easily tends to be insufficient. In addition to that, the soldering temperature decreases. Hence, soldering failure tends to occur. In an extreme case, there occurs a problem that the connection lead wires come out of the semiconductor substrate during handling the solar cell.

Therefore, various means have been tried in hot dip plating steps so as to make the hot-dip solder plated layer of the electrode wire material even in the thickness as much as possible. For example, JP 7-243014-A (Patent Document 1) describes a technique of solidifying the plated layer under the condition that the strip-like material led out of a hot dip plating bath is rolled on a roll while the plated layer deposited on the surface of the material is still in molten state or solidifying the plated layer while the strip-like material adhering the plated layer being sandwiched between a pair of endless belts. On the other hand, for example, JP 60-15937-A (Patent Document 2) proposes, as a conductive material with a small difference of the thermal expansion coefficient from that of the semiconductor material, a clad material composed of a plate of Invar (typical composition: Fe-36% Ni) of an Fe-Ni alloy, and copper plates unitedly formed on the both faces of the Invar plate.
Patent Document 1: Japanese Unexamined Patent Publication No. 7-243014
Patent Document 2: Japanese Unexamined Patent Publication No. 60-15937
JP 11 021660 A discloses an electrode wire material comprising a core material formed of a strip-like conductive material; and a hot-dip solder plated layer formed on a surface of the core material.
US 5 151 373 A, which document is considered to represent the most relevant state of the art, discloses an electrode wire material comprising a core material formed of a strip-like conductive material; and a solder layer formed on a surface of the core material, wherein the core material has a recessed portion for storing molten solder along the longitudinal direction thereof, the recess portion having an opening width in the lateral direction of the core material being 90% or more of the width of the core material and the recess portion is formed in the recessed side of the core material in a curved shape of the cross section in the perpendicular direction.

### DISCLOSURE OF THE INVENTION

### PROBLEMS TO BE SOLVED BY THE INVENTION

As described above, to improve the solderability of an electrode wire material to be soldered to a semiconductor substrate, the hot-dip solder plated layer formed on the electrode wire material is better to be made as flat as possible. However, as described in Patent Document 1, to solidify the plated layer in flat state, it is required to prepare flattening rolls and endless belts, strictly control the tension of the core material (a strip-like material) which is an object material to be plated, and carry out complicated operations for changing the roll diameter and the belt length corresponding to the plating temperature and plating speed.

In view of the foregoing, it is an object of the invention to provide a method for producing an electrode wire material having excellent solderability without using flattening solidifying means such as flattening rolls and endless belts.

### MEANS FOR SOLVING THE PROBLEMS

An electrode wire material produced by the method of the invention comprises a core material formed of a strip-like conductive material and a hot-dip solder plated layer formed on a surface of the core material. The core material has a recessed part formed therein along the longitudinal direction for storing molten solder and the hot-dip solder plated layer is filled in the recessed part.
According to the electrode wire material, since the recessed part for storage of molten solder are formed in the core material of the electrode wire material, when the molten solder is supplied to the recessed part is solidified, even if the surface tension works on the molten solder, the center portion of the molten solder is hardly swollen and thus the hot-dip solder plated layer tends to be flat. Hence, when the electrode wire material is mounted on the surface of the soldered part such as a solder belt of the semiconductor substrate in such a manner that the hot-dip solder plated layer makes contact with the soldered part, the contact region of the soldered part and the hot-dip solder plated layer is widened as compared with that of a conventional hill-like hot-dip solder plated layer, and thus the thermal conductivity is improved. Therefore, the solderability of the electrode wire material is improved and excellent bondability can be obtained.

With respect to the electrode wire material, when the molten solder supplied to the recessed part for storing molten solder solidifies, to make the molten solder easily flat in the entire width of the core material, it is desirable to form the recessed part for storing molten solder in such a manner that the opening width of the recessed part in the lateral direction of the core material is 90% or higher in the width of the core material. Further, in order to make the opening width of the recessed part for storing molten solder wide, it is desirable to form a recessed part for storing molten solder in a recessed side of the core material which is formed to be dish-like or curved cross-sectional shape in the perpendicular direction in relation to the longitudinal direction. Since such a shape is simple and easy for forming, it is excellent in industrial productivity.

The core material is desirably formed of a clad material comprising copper layers formed on both faces of an interlayer composed of a low thermal expansion Fe alloy selected from an Fe-Ni alloy such as Invar or an Fe-Ni-Co alloy such as Kovar (trade name). Use of such a clad material for the core material makes it possible to remarkably decrease the thermal expansion coefficient as compared with that of a copper material, and then the thermal stress generated in the semiconductor substrate, which is soldered with the electrode wire material, can be decreased, and hence, a semiconductor substrate with further thinner thickness is made usable to lead to weight saving of the semiconductor substrate and cost down of the material.

The hot-dip solder plated layer can be formed of a lead-free solder material having a melting point of 130°C or higher and 300°C or lower. Such a solder scarcely causes environmental pollution with lead and its melting point is low, so that the solder is advantageous in a point that thermal stress is hardly generated when the electrode wire material is soldered to the semiconductor substrate.

Further, a solar cell of the invention comprises a semiconductor substrate formed of a semiconductor having PN junction and a connection lead wire soldered to a plurality of front face electrodes formed on the surface of the semiconductor substrate. The connection lead wire is composed of the electrode wire material soldered to a plurality of front face electrodes formed on the semiconductor substrate with the hot-dip solder plated layer.
According to the solar cell, since the connection lead wire is composed of the electrode wire material soldered to the front face electrodes on the semiconductor substrate with the flatten hot-dip solder plated layer filled in the recessed part for storing molten solder, the connection lead wire is firmly bonded to the semiconductor substrate and hardly come out of the semiconductor substrate, and thus the solar cell has excellent durability.

### EFFECTS OF THE INVENTION

According to the electrode wire material of the invention, since the hot-dip solder plated layer filled in the recessed part for storing molten solder in the core material is easy to be flatten in the surface as compared with conventional one, it is made possible to improve the solderability to the soldered part formed on a semiconductor substrate or the like and then improve the bonding durability of the electrode wire material.
Further, according to the solar cell of the invention, since the connection lead wire is formed of the electrode wire material of which the hot-dip solder plated layer filled in the recessed part for storing molten solder is soldered to a plurality of the front face electrodes of the semiconductor substrate, the connection lead wire is firmly bonded to the semiconductor substrate and hardly come out of the semiconductor substrate, and then the solar cell enhances the handling properties and durability.

### BRIEF DESCRIPTION OF THE DRAWINGS

Fig. 1 is a transverse cross-sectional view of an electrode wire material according to one embodiment of the invention.
Fig. 2 is a transverse cross-sectional view of an electrode wire material according to another embodiment of the invention.
Fig. 3 is a transverse cross-sectional view of an electrode wire material according to the other embodiment of the invention
Fig. 4 is a schematic perspective view of a solar cell according to an embodiment of the invention.
Fig. 5 is a transverse cross-sectional view of a conventional electrode wire material.

### BEST MODE FOR CARRYING OUT OF THE INVENTION

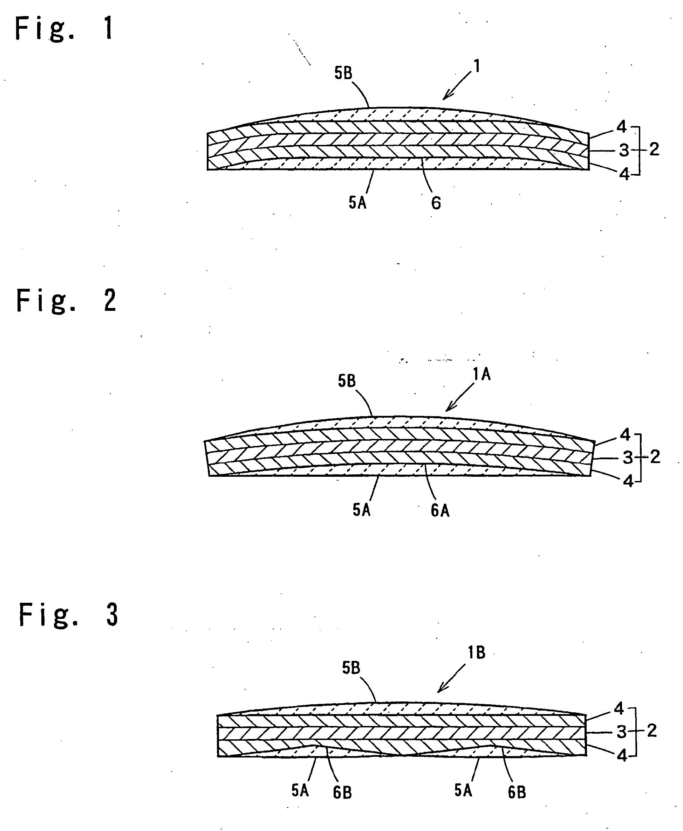

Fig. 1 shows an electrode wire material according to the first embodiment of the invention and the electrode wire material 1 comprises a strip-like core material 2 formed of a conductive material and hot-dip solder plated layers 5A, 5B formed on the both faces.

The core material 2 is formed of a clad material comprising an interlayer 3 of Invar and copper layers 4, 4 with same cross sectional areas in both faces of the interlayer. Inver is an Fe-Ni alloy containing about 35 to 38 mass% of Ni and is excellent in processibility and has a thermal expansion coefficient of about 1.2 × 10⁻⁶/°C (in the case Ni = 36.5 mass %), which is greatly lower than 16.5 × 10⁻⁶/°C of copper. The ratio of the interlayer 3 and the copper layers 4 composing the core material 2 may be determined so as to adjust the thermal expansion coefficient in the plate face direction approximately same as that of a material of the semiconductor substrate, an object to be soldered thereto, for example silicon (thermal expansion coefficient: 3.5 × 10⁶/°C) and in general, the area ratio of the interlayer 3 in the cross section (transverse cross section) in the perpendicular direction to the longitudinal direction of the electrode wire material 1 may be adjusted to be about 20 to 60%. The width and thickness of the core material 2 may properly be determined depending on uses of the electrode wire material and in the case of use as a connection lead wire of a solar cell, the size of the core material is about 1 to 3 mm in width and 0.1 to 0.3 mm in thickness.

The core material 2 is so formed as to have a transverse cross sectional shape like a dish (dish-like cross sectional shape) recessed flatly in the center part of its one surface (the down face in the exemplified illustration). A recessed part 6 for storing molten solder is formed in the recessed side. The hot-dip solder plated layer 5A solidified from the molten solder is filled in the recessed part 6 and its surface is approximately flat. The depth of the recessed part is preferably about 10 to 30 µm in the deepest portion and the width (the opening width in the down face) is preferably about 90% or higher of the width of the core material 2. The upper limit of the width is not particularly limited and the opening may be formed in the entire width of the down face.

The recessed part 6 for storing molten solder can easily be formed by carrying out proper plastic forming or bending forming or the like for the strip-like material (a core raw material) of the clad material. In an example not part of the invention, the strip-like material is passed through forming rolls having dish-like cross sectional shape between rolls to easily form the recessed part. In the invention the strip-like material is obtained by slitting a plate-like clad material, the gap or the rotational speed of rotary blades of a slitter may be adjusted properly so as to carry out bending forming in the side end parts of the slit strip-like material.

The core material 2 so formed as to be like a dish is washed to have clean surface by acid pickling or with an organic solvent and then the core material 2 is passed through a molten solder bath to provide molten solder in the recessed part 6 of the core material 2. The surface of the molten solder supplied to and filled in the recessed part 6 of the core material 2 is easily made flat since the molten solder filled in the recessed part 6 is prevented from expansion in the center part because of the surface tension as compared with that in the case of forming no recessed part 6 (reference to Fig. 5).
Hence, according to supplying the molten solder so as to be almost fully filled in the recessed part 6, the surface of the molten solder stored in the recessed part 6 in the entire width of the core material 2, namely the surface of the hot-dip solder plated layer 5A after the solidification can be made flat.
To supply the recessed part 6 with the molten solder so as to be almost fully filled, the molten solder bath temperature and the plating speed are properly controlled at the time of molten solder plating or after the core material 2 is dipped in a molten solder bath and pulled out, the excess molten solder rising up in the opening of the recessed part 6 is removed by blowing hot air or scraped out by a proper scraping member.

Alloys usable as the solder material for forming the hot-dip solder plated layers 5A, 5B are Sn-Pb alloy, Sn-0.5 to 5 mass% Ag alloy, Sn-0.5 to 5 mass% Ag-0.3 to 1.0 mass% Cu alloy, Sn-0.3 to 1.0 mass% Cu alloy, Sn-1.0 to 5.0 mass% Ag-5 to 8 mass% In alloy, Sn-1.0 to 5.0 mass% Ag-40 to 50 mass% Bi alloy, Sn-40 to 50 mass% Bi alloy, and Sn-1.0 to 5.0 mass% Ag-40 to 50 mass% Bi-5 to 8 mass% In alloy respectively a melting point of about 130 to 300°C. Since Pb is harmful for human being and possibly pollutes the natural environments, in terms of pollution prevention, Sn-Ag alloy, Sn-Ag-Cu alloy, Sn-Cu alloy, Sn-Ag-In alloy, and Sn-Ag-Bi alloy free of Pb respectively are preferable for the solder material. Also, these respective solder materials may contain one ore more elements selected from about 50 to 200 ppm of P, several to several tens ppm of Ga, several to several tens ppm of Gd, and several to several tens ppm of Ge. The hot-dip solder plated layers 5A, 5B may be made to have multilayer structure by using a variety of pure metals such as Sn, Ag and Cu, or their alloys. In such a case, the thickness of the respective layers is adjusted so as to be a prescribed alloy after melting. Such a multilayer structure is advantageous in a point that the components of the desired solder material can easily be adjusted by simply adjusting the thickness of the respective layers. The multilayer structure can be formed easily by successively carrying out metal plating.

In the above-mentioned embodiment, the core material 2 has a dish-like shape as the transverse cross sectional shape of which the center bottom part of the recessed part 6 is flat, but the cross sectional shape of the core material is not particularly limited to such a shape and just like the electrode wire material 1A shown in Fig. 2, the cross section shape of the core material 2 may be curved as a whole. In such a case, the recessed part 6A for storing molten solder has a bottom face with curved cross-section. Also, just like the electrode wire material 1B shown in Fig. 3, the cross section shape may have two partial recessed parts 6B, 6B with triangular cross sectional shape in the copper layer 4 in the down face side of the core material 2. In this case, the recessed part for storing molten solder is composed of these partial recessed parts 6B, 6B. The partial recessed parts 6B, 6B can be formed easily by passing a strip-like plate of a clad material through forming rolls of which one has triangularly projected parts in the roll surface and pressurizing the strip-like plate by the forming rolls. Of course, the cross-sectional shapes of the partial recessed parts and the number of these parts are not limited as illustrated and proper shapes and number may be selected. In the embodiments shown in Fig. 2 and Fig. 3, the same reference numerals are assigned to the same constituents of the electrode wire material 1 of the embodiment of Fig. 1.

In the electrode wire materials 1, 1A, and 1B according to the above-mentioned embodiments, a clad material composed of an interlayer 3 composed of a Fe-35 to 38 mass% Ni alloy and copper layers 4, 4 formed on both faces of the interlayer 3 is used for the core material 2. The interlayer may be composed of a Fe-29 to 37 mass% Ni-6 to 18 mass% Co alloy with a low expansion coefficient such as Kovar (trade name) or pure Fe.
The core material may entirely be composed of a copper material, but when the core material is formed of the clad material (particularly, of which the interlayer is composed of a low thermal expansion Fe alloy such as Fe-Ni alloy or a Fe-Ni-Co alloy), the thermal expansion coefficient of the material is made similar to that of a semiconductor such as silicon and then the thermal stress can be lessened further at the time of soldering the electrode wire material to the semiconductor substrate.

Fig. 4 shows a solar cell of which connection lead wires are formed of the electrode wire material 1 according to the first embodiment. The solar cell comprises a semiconductor substrate 11 of a silicon semiconductor having PN junction and connection lead wires 13 soldered to a plurality of front face electrodes 12 formed linearly on the surface of the semiconductor substrate 11. The semiconductor substrate 11 has rear face electrodes formed on the rear face of it.

On the semiconductor substrate 11 before the connection lead wires 13 being soldered, solder belts are arranged at right angles to a plurality of the front face electrodes 12 so as to connect to the front face electrodes 12. Along the solder belt, the electrode wire material 1 is mounted on the semiconductor substrate 11 so as to make the hot-dip solder plated layer 5A of the electrode wire material 1 to contact with the solder belt. And the solder belt on the semiconductor substrate 11 and the hot-dip solder plated layer 5A of the electrode wire material 1 are melted together to solder the electrode wire material 1 on the surface of the semiconductor substrate 11. Accordingly, the connection lead wires 13 formed of the electrode wire material 1 can be bonded to the semiconductor substrate 11.

According to the solar cell, since the hot-dip solder plated layer 5A of the electrode wire material 1 is filled in the recessed part 6 and made the surface flat to obtain excellent solderability, the connection lead wires 13 are firmly bonded to the semiconductor substrate 11. Hence, the connection lead wires hardly come out of the semiconductor substrate and are excellent in durability. As the connection lead wires 13 in the solar cell, not only the electrode wire material 1 of the first embodiment but also electrode wire materials 1A, 1B according to other embodiments can be used and similar effects can be brought by using any of these electrode wire materials.

Hereinafter, the electrode wire material of the invention will be described more specifically by way of examples thereof, however it should be understand that the invention be limited to the examples.

### EXAMPLES

A clad material (0.18 mm thick) comprising a middle layer with a thickness of 60 µm composed of Invar (Fe-36.5 mass% Ni) and copper layers with each thickness of 60 µm formed on both faces of the interlayer was prepared. Strip-like materials with each width of 2 mm were produced from the clad material by a slitter and the strip-like materials were further cut into pieces with each length of 40 mm to obtain core materials related to examples. When slitting by the slitter, the intervals of rotary blades were adjusted so as to carry out bending forming in the end parts in the width direction of the each strip-like material to make the transverse cross sectional shape of the core material dish-like as shown in Fig.1. The cross-sectional shape was observed by an optical microscope (magnification about 200 times) to find that the deepest depth in the recessed part formed in the recessed side of the core material was about 20 µm and the opening width of the recessed part was about 95% of the core material width. On the other hand, core materials with each length of 40 mm related to comparative examples were produced from a pressed flat wire with a thickness of 0.18 mm and a width of 2 mm composed of copper.

After these core materials were cleaned in the surface with an organic solvent (acetone), each of the core materials was dipped in a molten solder bath (solder composition: Sn-3.5 mass% Ag; melting point: 220°C, and bath temperature: 300°C) and quickly pulled out to form hot-dip solder plated layer on the surface of the core material. After this manner, an electrode wire material was obtained. With respect to the electrode wire materials of the examples, each hot-dip solder plated layer was filled in the recessed part and almost flat in the surface in the entire width of the core material. On the other hand, each of the electrode wire materials of the comparative examples, as shown in Fig. 5, showed a hill-like shape expanded in the center part from side end parts of the core material.

The electrode wire materials of the examples and comparative examples produced in such a manner were coated with a proper amount of a flux (NS-30, manufactured by Nihon Superior Co., Ltd.). Each electrode wire material was mounted on an oxygen-free copper strip plate (0.5 mm thick, 4 mm wide, and 40 mm long) in such a manner that the hot-dip solder plated layer got contact with the center part in the width direction of the copper strip plate along the longitudinal direction. The copper strip plate and the electrode wire material thereon were put on the hot plate and heated (kept at 260°C for 1 minute) to solder the electrode wire material to the copper strip plate.

After that, the electrode wire material and copper strip plate being pulled in the opposed directions with a tensile tester to peel the electrode wire material from the copper plate, the tensile force required for peeling was measured. The test was repeated 5 times for each sample and the average value was calculated. As a result, the tensile force was 14.1 N for the examples and 8.1 N for the comparative examples. Accordingly, the electrode wire materials of the examples had joining force of about 1.7 times as compared to that of the electrode wire materials of the comparative example and thus it was confirmed that the electrode wire materials of the examples had excellent solderability.

## Claims

1. A method of producing an electrode wire material (1) comprising a core material (2) formed of a strip-like conductive material and a solder layer (5a) formed on a surface of the core material, wherein the core material (2) has a recessed portion (6) for storing solder along the longitudinal direction thereof, the recess portion (6) having an opening width in the lateral direction of the core material (2) being 90% or more of the width of the core material (2) and the recess portion (6) is formed in a bent side of the core material (2) in a dish-like or curved shape of the cross section in the perpendicular direction and the solder layer (5A) is filled in the recessed portion,
**characterized in that** said method comprises the steps of:
obtaining a plurality of core materials (2) by slitting a conductive plate-like material into strip-like materials with a slitter, the gap or the rotational speed of rotary blades of the slitter being adjusted so that both lateral side end portions of each strip-like material are bent to form the recess portion (6); and
objecting each of the core materials (2) to a hot-dip solder plating by passing through a molten solder bath to make the recess portion (6) thereof filled with the molten solder so as to form the solder layer (5a) filled in the recessed portion (6) as a hot-dip solder plated layer.

2. The method of producing an electrode wire material according to claim 1 , wherein the conductive plate-like material (2) is formed of a clad material comprising an interlayer (3) of a low thermal expansion Fe alloy selected from an Fe-Ni alloy or Fe-Ni-Co alloy and copper layers (4) formed on both surfaces of the interlayer (3).

3. The method of producing an electrode wire material(1) according to any of the preceding claims, wherein the solder is composed of a solder material having a melting point of 130°C or higher and 300°C or lower and free of lead.

4. The method of producing an electrode wire material (1) according to any of the preceding claims, wherein the strip-like material (2) has a width in the lateral direction of about 1 mm to 3 mm and a thickness of about 0.1 mm to 0.3 mm.

## Patentansprüche

1. Verfahren zum Herstellen eines Elektrodendrahtmaterials (1) mit einem aus einem streifenartigen leitfähigen Material ausgebildeten Kernmaterial (2) und einer auf einer Oberfläche des Kernmaterials ausgebildeten Lötmittelschicht (5a), wobei das Kernmaterial (2) einen zurückgesetzten Teilabschnitt (6) zum Lagern eines Lötmittels entlang seiner Längsrichtung hat, wobei der zurückgesetzte Teilabschnitt (6) eine Öffnungsbreite in der Längsrichtung hat, die 90% oder mehr von der Breite des Kernmaterials (2) ist, und der zurückgesetzte Teilabschnitt (6) in einer gebogenen Seite des Kernmaterials (2) in einer schalenartigen oder gekrümmten Form des Querschnitts in der senkrechten Richtung ausgebildet ist und die Lötmittelschicht (5A) in den zurückgesetzten Teilabschnitt gefüllt ist,
**dadurch gekennzeichnet, dass** das Verfahren die folgenden Schritte aufweist:
Erhalten einer Vielzahl von Kernmaterialien (2) durch Schneiden eines leitfähigen plattenartigen Materials in streifenartige Materialien mit einer Schneideeinrichtung, wobei der Spalt oder die Drehgeschwindigkeit von sich drehenden Schneiden der Schneideeinrichtung so eingestellt wird, dass beide Lateralseitenendteilabschnitte jedes streifenartigen Materials gebogen werden, um den zurückgesetzten Teilabschnitt (6) auszubilden; und
Aussetzen jedes der Kernmaterialien einem Beschichten mittels heißem Tauchlöten durch Führen durch ein Bad mit geschmolzenem Lötmittel, um zu veranlassen, dass sein zurückgesetzter Teilabschnitt (6) mit geschmolzenem Lötmittel gefüllt wird, um die in den zurückgesetzten Teilabschnitt (6) gefüllte Lötmittelschicht (5a) als durch heißes Tauchlöten beschichtete Schicht auszubilden.

2. Verfahren zum Herstellen eines Elektrodendrahtmaterials nach Anspruch 1, wobei das leitfähige plattenartige Material (2) aus einem Überzugsmaterial mit einer Zwischenschicht (3) aus einer Fe-Legierung mit geringer thermischer Expansion, die aus einer Fe-Ni-Legierung oder einer Fe-Ni-Co-Legierung ausgewählt ist, und auf beiden Oberflächen der Zwischenschicht (3) ausgebildeten Kupferschichten (4) ausgebildet ist.

3. Verfahren zum Herstellen eines Elektrodendrahtmaterials (1) nach einem der vorangehenden Ansprüche, wobei das Lötmittel aus einem Lötmittelmaterial mit einem Schmelzpunkt von 130°C oder höher und 300°C oder niedriger und frei von Blei besteht.

4. Verfahren zum Herstellen eines Elektrodendrahtmaterials (1) nach einem der vorangehenden Ansprüche, wobei das streifenartige Material (2) eine Breite in der lateralen Richtung von etwa 1 mm bis 3 mm und eine Dicke von etwa 0.1 mm bis 0.3 mm hat.

## Revendications

1. Procédé de fabrication d'un matériau de fil-électrode (1) comprenant un matériau noyau (2) constitué d'un matériau conducteur de type bande et une couche brasurée (5a) formée sur une surface du matériau noyau, le matériau noyau (2) ayant une partie creuse (6) servant au stockage de brasure le long du sens longitudinal de celle-ci, la partie creuse (6) ayant une largeur d'ouverture dans le sens latéral du matériau noyau (2) qui est équivalente à 90% ou plus de la largeur du matériau noyau (2) et la partie creuse (6) est formée dans une face courbée du matériau noyau (2), dans une forme de type assiette ou courbée de la section transversale dans le sens perpendiculaire et la couche brasurée (5A) est reçue dans la partie creuse,
**caractérisé en ce que** ledit procédé comprend les étapes consistant à
obtenir une pluralité de matériaux noyau (2) en découpant un matériau conducteur de type plaque en matériaux de type bande à l'aide d'une découpeuse, l'espace ou de la vitesse de rotation des lames rotatives de la découpeuse étant ajustés de manière que les deux portions d'extrémité de face latérale de chaque matériau de type bande sont courbées afin de former la partie creuse (6) et à
exposer chacun des matériaux noyau (2) à un empilement de brasure à chaud en passant à travers un bain de brasure fondue pour remplir la partie creuse (6) de ceux-ci de manière à former la couche brasurée (5a) reçue dans la partie creuse (6) comme couche empilée à chaud.

2. Procédé de fabrication d'un matériau de fil-électrode suivant la revendication 1, dans lequel le matériau conducteur de type plaque (2) est formé par un matériau de gainage comprenant une couche intermédiaire (3) constituée d'un alliage de Fe à faible dilatation thermique sélectionné parmi un alliage Fe-Ni ou un alliage Fe-Ni-Co et de couches de cuivre (4) formées sur les deux surfaces de la couche intermédiaire (3).

3. Procédé de fabrication d'un matériau de fil-électrode (1) suivant une quelconque des revendications précédentes, dans lequel la brasure est composée d'un matériau de brasure ayant un point de fusion de 130°C ou plus et de 300°C ou moins et qui est exempt de plomb.

4. Procédé de fabrication d'un matériau de fil-électrode (1) suivant une quelconque des revendications précédentes, dans lequel le matériau de type bande (2) a une largeur de 1 mm à 3 mm environ dans le sens latéral et une épaisseur de 0,1mm à 0,3 mm.
